(19) 

**Europäisches Patentamt**
**European Patent Office**
**Office européen des brevets**

(11) **EP 4 772 896 A1**

(12) **EUROPEAN PATENT APPLICATION**
published in accordance with Art. 153(4) EPC

(43) Date of publication:
**08.07.2026 Bulletin 2026/28**

(21) Application number: **25867259.1**

(22) Date of filing: **27.08.2025**

(51) International Patent Classification (IPC):
*G01R 31/367* (2019.01)    *G01R 31/396* (2019.01)
*G01R 31/392* (2019.01)    *G07F 17/18* (2006.01)

(52) Cooperative Patent Classification (CPC):
**G01R 31/367; G01R 31/392; G01R 31/396;**
**G07F 17/18**

(86) International application number:
**PCT/KR2025/013086**

(87) International publication number:
**WO 2026/079662 (16.04.2026 Gazette 2026/16)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **08.10.2024 KR 20240136292**

(71) Applicant: **LG ENERGY SOLUTION, LTD.**
**Seoul 07335 (KR)**

(72) Inventors:
• **YEOM, In Cheol**
  **Daejeon 34122 (KR)**
• **ROH, Ye Rim**
  **Daejeon 34122 (KR)**

(74) Representative: **Plasseraud IP**
**104 Rue de Richelieu**
**CS92104**
**75080 Paris Cedex 02 (FR)**

(54) **DATA ANALYSIS DEVICE AND METHOD THEREOF**

(57)    A data analysis device according to an embodiment of the present disclosure may include a memory configured to store at least one instruction and at least one processor configured to execute the at least one instruction, and the at least one processor may acquire a set of data of a battery cell and a time interval at which data included in the set of data is acquired, identify a plurality of data regions including at least one of a plurality of first ranges for dividing a first state variable of the battery cell by a first magnitude, a plurality of second ranges for dividing a second state variable of the battery cell by a second magnitude, or any combination thereof, and diagnose a state of the battery cell based on battery data regions including the set of data among the plurality of data regions and a time that is identified according to the time interval and in which the data is included in each of the battery data regions.

FIG.6

**Description**

## TECHNICAL FIELD

### Cross-reference to Related Applications

This application claims priority from Korean Patent Application No. 10-2024-0136292, filed on October 8, 2024, the disclosure of which is incorporated by reference herein.

### Technical Field

Embodiments disclosed herein relate to a data analysis device and a method thereof.

## BACKGROUND ART

In recent years, research and development for secondary batteries have been actively conducted. Here, secondary batteries are batteries capable of being recharged and discharged, and may be interpreted to encompass both conventional Ni/Cd batteries, Ni/MH batteries, or the like, and recent lithium ion batteries. In recent years, the lithium ion batteries have expanded their range of use to power sources for electric vehicles, making the batteries attract attention as a next-generation energy storage medium.

As various electronic devices become widespread due to the Fourth Industrial Revolution, battery usage is rapidly increasing. Batteries are gaining attention as an essential energy source in various fields such as electric vehicles, portable electronic devices, and renewable energy storage systems, and accordingly, the importance of battery state diagnosis technology for improving battery performance and reliability is increasing.

In particular, technology for classifying data to increase the accuracy of battery life diagnosis is attracting attention. When the accuracy of battery life diagnosis is improved, battery maintenance costs may be reduced and battery usage may be optimized.

## DISCLOSURE OF THE INVENTION

### TECHNICAL PROBLEM

Embodiments disclosed herein are intended to provide a data analysis device for categorizing a set of data acquired from a battery unit and a method thereof.

Embodiments disclosed herein are intended to provide a data analysis device for adjusting a magnitude of a state variable that categorizes a set of data acquired from a battery unit and a method thereof.

Embodiments disclosed are intended to provide a data analysis device for determining a reference time for identifying whether the time during which a battery unit is not operating is a rest period and a method thereof.

The technical problems of the present disclosure are not limited to those mentioned above, and other objectives not mentioned will be clearly understood by those skilled in the art from the following descriptions.

## TECHNICAL SOLUTION

A data analysis device according to an embodiment of the present disclosure may include a memory configured to store at least one instruction and at least one processor configured to execute the at least one instruction.

According to an embodiment, the at least one processor may acquire a set of data of a battery cell and a time interval at which data included in the set of data is acquired, identify a plurality of data regions including at least one of a plurality of first ranges for dividing a first state variable of the battery cell by a first magnitude, a plurality of second ranges for dividing a second state variable of the battery cell by a second magnitude, or any combination thereof, and diagnose a state of the battery cell based on battery data regions including the set of data among the plurality of data regions and a time that is identified according to the time interval and in which the data is included in each of the battery data regions.

According to an embodiment, the at least one processor may identify a period corresponding to a first time interval during which the data is acquired as a rest period of the battery cell when the first time interval is within a specified range and identify a period corresponding to a second time interval during which the data is acquired as an operating period of the battery cell when the second time interval is outside the specified range.

According to an embodiment, the specified range may be determined based on a median value of time intervals at which data included in the set of data is acquired.

According to an embodiment, the at least one processor may diagnose a state of another battery cell of the same type as the battery cell based on a relationship between the set of data and the state of the battery cell, according to a set of data of the other battery cell.

According to an embodiment, when a discrepancy between the set of data and the battery data regions is greater than or equal to a reference value, the at least one processor may decrease the first magnitude and the second magnitude until the discrepancy becomes smaller than the reference. The discrepancy may include a Kullback-Leibler (KL) divergence between a first probability distribution (probability mass function (PMF)) for the set of data and a second probability distribution (PMF) for the battery data regions.

According to an embodiment, the at least one processor may acquire the first probability distribution (PMF) for a specified period based on a value obtained by dividing a time during which the data is acquired by a time corresponding to the specified period, and acquire the second probability distribution (PMF) for the specified period based on a value obtained by dividing a time during which the data is included in each of the battery data regions by the time corresponding to the specified period.

According to an embodiment, a minimum value of the first state variable among the plurality of data regions may be determined based on a minimum value of the first state variable in the data and the first magnitude, and a maximum value of the first state variable among the plurality of data regions may be determined based on a maximum value of the first state variable in the data and the first magnitude.

According to an embodiment, the time interval of the first data included in the set of data and acquired for the first time during a specified period may include a time interval from a start time of the specified period to an acquisition time of the first data, and the time interval of the second data included in the set of data and acquired for the last time during the specified period may include a time interval from an end time of the specified period to an acquisition time of the second data.

A data analysis method according to another embodiment of the present disclosure may include acquiring a set of data of a battery cell and a time interval at which data included in the set of data is acquired, identifying a plurality of data regions including at least one of a plurality of first ranges for dividing a first state variable of the battery cell by a first magnitude, a plurality of second ranges for dividing a second state variable of the battery cell by a second magnitude, or any combination thereof, and diagnosing a state of the battery cell based on battery data regions including the set of data among the plurality of data regions and a time that is identified according to the time interval and in which the data is included in each of the battery data regions.

According to an embodiment, the data analysis method may further include identifying a period corresponding to a first time interval during which the data is acquired as a rest period of the battery cell when the first time interval is within a specified range and identifying a period corresponding to a second time interval during which the data is acquired as an operating period of the battery cell when the second time interval is outside the specified range.

According to an embodiment, the specified range may be determined based on a median value of time intervals at which data included in the set of data is acquired.

According to an embodiment, the data analysis method may further include diagnosing a state of another battery cell of the same type as the battery cell based on a relationship between the set of data and the state of the battery cell, according to a set of data of the other battery cell.

According to an embodiment, the data analysis method may further include decreasing, when a discrepancy between the set of data and the battery data regions is greater than or equal to a reference value, the first magnitude and the second magnitude until the discrepancy becomes smaller than the reference. The discrepancy may include a Kullback-Leibler (KL) divergence between a first probability distribution (probability mass function (PMF)) for the set of data and a second probability distribution (PMF) for the battery data regions.

According to an embodiment, the data analysis method may further include acquiring the first probability distribution (PMF) for a specified period based on a value obtained by dividing a time during which the data is acquired by a time corresponding to the specified period and acquiring the second probability distribution (PMF) for the specified period based on a value obtained by dividing a time during which the data is included in each of the battery data regions by the time corresponding to the specified period.

According to an embodiment, a minimum value of the first state variable among the plurality of data regions may be determined based on a minimum value of the first state variable in the data and the first magnitude, and a maximum value of the first state variable among the plurality of data regions may be determined based on a maximum value of the first state variable in the data and the first magnitude.

According to an embodiment, the time interval of the first data included in the set of data and acquired for the first time during a specified period may include a time interval from a start time of the specified period to an acquisition time of the first data, and the time interval of the second data included in the set of data and acquired for the last time during the specified period may include a time interval from an end time of the specified period to an acquisition time of the second data.

## ADVANTAGEOUS EFFECTS

The present technology can categorize a set of data acquired from a battery unit.

In addition, the present technology can adjust a magnitude of each state variable that categorizes a set of data acquired from a battery unit.

In addition, according to embodiments disclosed herein, the present technology can determine a reference time for identifying whether the time during which a battery unit is not operating is a rest period.

Besides, various effects may be provided that are directly or indirectly identified through the present disclosure.

## BRIEF DESCRIPTION OF THE DRAWINGS

FIG. 1 is a block diagram illustrating a battery pack in a data analysis device and a data analysis method according to an embodiment of the present disclosure.
FIG. 2 is a block diagram illustrating a configuration of a data analysis device, in a data analysis device and a data analysis method according to an embodiment of the present disclosure.

FIG. 3 illustrates an example of a data region, in the data analysis device and the data analysis method according to an embodiment of the present disclosure.

FIG. 4 illustrates an example of a time interval during which data is acquired, in a data analysis device and a data analysis method according to an embodiment of the present disclosure.

FIG. 5 illustrates an example of a flow of operations of a data analysis device for determining a first magnitude and a second magnitude, in a data analysis device and a data analysis method according to an embodiment of the present disclosure.

FIG. 6 illustrates an example of a flow of operations of a data analysis device for diagnosing the state of a battery cell, in a data analysis device and a data analysis method according to an embodiment of the present disclosure.

FIG. 7 is a block diagram illustrating a hardware configuration of a computing system that performs a data analysis method, in a data analysis device and a data analysis method according to an embodiment of the present disclosure.

## MODE FOR CARRYING OUT THE INVENTION

Below, some embodiments disclosed herein are described with reference to the accompanying drawings of various embodiments of the present disclosure. However, this is not intended to limit the present technology to the specific embodiments, and it is to be construed to include various modifications, equivalents, and/or alternatives of embodiments of the present technology.

In adding reference numerals to the components of each drawing, it should be noted that the same components are given the same reference numerals as much as possible even though they are shown on different drawings. In addition, in describing various embodiments disclosed herein, when a detailed description of a related known configuration or function is determined to hinder understanding of the embodiments of the present invention, the detailed description thereof is omitted. It is to be understood that a singular form of a noun corresponding to an item may include one or more of the things, unless the relevant context clearly indicates otherwise.

In addition, in describing a component of the embodiments of the present disclosure, terms such as first, second, A, B, (a), (b), etc. may be used. These terms are only for distinguishing the component from other components, and the essence, sequence, or order of the component may not be limited by the terms. In addition, unless otherwise defined, all terms used herein, including technical or scientific terms, have the same meaning as commonly understood by those of ordinary skill in the art to which the embodiments disclosed herein belong. Terms, such as those defined in commonly used dictionaries, should be interpreted as having a meaning that is consistent with their meaning in the context of the related art and will not be interpreted in an idealized or overly formal sense unless expressly so defined herein.

In addition, in the present disclosure, in order to determine whether a specific condition is satisfied or fulfilled, expressions "more than" or "less than" may be used, but this is only a description for expressing an example and does not exclude descriptions of "equal to or more than" or "less than or equal to." A condition described as "equal to or more than" may be replaced with "more than," a condition described as "less than or equal to" may be replaced with "less than," and a condition described as "equal to or more than and less than" may be replaced with "more than and less than or equal to." In addition, hereinafter, "A to B" mean at least one of the elements from A (inclusive of A) to B (inclusive of B).

In the present disclosure, each of phrases such as "A or B," "at least one of A and B," "at least one of A or B," "A, B or C," "at least one of A, B and C," or "at least one of A, B, or C," may include any one of the items listed in the phrase, or all possible combinations of the phrases.

In the present specification, It is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or via a third element.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the described components may include a single entity or multiple entities, and some of the plurality of entities may be disposed separately from other components. According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

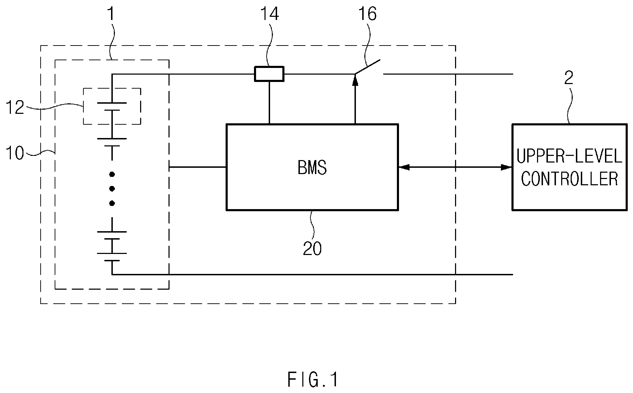

Hereinafter, embodiments of the present disclosure will be described in detail with reference to FIGS. 1 to 7.

FIG. 1 is a block diagram illustrating a battery pack in a data analysis device and a data analysis method according to an embodiment of the present disclosure.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). For this purpose, the battery unit 12 may be electrically connected to the target device. Here, the target device may include an electrical, electronic, or mechanical device that operates by receiving power from the battery pack 1. For example, the target device may be an electric vehicle (EV) or an energy storage system (ESS), but is not limited thereto.

According to an embodiment, the battery unit 12 may include at least one battery cell 10 that is rechargeable and dischargeable. Here, the battery cell 10 may be a basic unit of a battery cell that may be used by being charged and discharged with electric energy. For example, the battery cell 10 may be a lithium ion (Li-ion) battery, a lithium ion (Li-ion) polymer battery, a nickel cadmium (Ni-Cd) battery, a nickel hydrogen (Ni-MH) battery, or the like, and may not be limited thereto.

According to an embodiment, a plurality of battery units 12 may be connected in series or in parallel. For example, the battery unit 12 may be a battery module, a battery bank, or a collection of battery cells (cell-to-pack structure).

According to an embodiment, the sensor unit 14 may acquire information related to the battery unit 12. According to an embodiment, the sensor unit 14 may acquire values (or information) related to the state of each of the battery units 12 or battery cells 10. In an embodiment, the state-related values may include one or more values for a voltage, current, resistance, state of charge (SOC), state of health (SOH), temperature of the battery cell, or a combination thereof.

According to an embodiment, the sensor unit 14 may provide information on each of the plurality of battery units 12 to the battery management system 20.

According to an embodiment, the switching unit 16 may include a device for controlling the current flow for charging or discharging the battery unit 12. For example, the switching unit 16 may include at least one relay and/or magnetic contactor, depending on the specifications of the battery pack 1.

According to an embodiment, the battery management system (BMS) 20 may control or manage the battery pack 1 to prevent overcharge and over-discharge by monitoring the voltage, current, temperature, and the like of the battery pack 1. For example, the battery management system 20 may be an interface for receiving values obtained by measuring the above-mentioned various parameters, and may include a plurality of terminals, a circuit connected to the terminals to process input values, or the like. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of the relay, the contactor, or the like.

According to an embodiment, the operation of the battery management system 20 may be performed by the BMS (battery management system) in a vehicle, as well as by various devices such as a server, a cloud, a charger, a discharger, or the like.

An upper-level controller 2 may transmit a control signal for the plurality of battery units 12 to the battery management system 20. Accordingly, the operation of the battery management system 20 may be controlled based on the signal received from the upper controller 2.

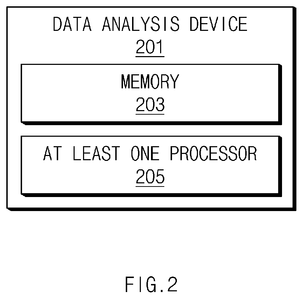

According to an embodiment, the battery management system 20 may include a data analysis device 201 in FIG. 2. In another embodiment, the battery management system 20 may be a system different than the data analysis device 201 in FIG. 2. That is, the data analysis device 201 in FIG. 2 may be included in the battery pack 1 or may be configured as another device external to the battery pack 1. For convenience of description, the following description assumes that the data analysis device 201 is configured as another device external to the battery pack 1. In addition, the operation of the data analysis device 201 below may be performed by a battery management system (BMS) in the vehicle, as well as by various devices such as a server, a cloud, a charger, a discharger, or the like.

FIG. 2 is a block diagram illustrating a configuration of a data analysis device, in a data analysis device and a data analysis method according to an embodiment of the present disclosure.

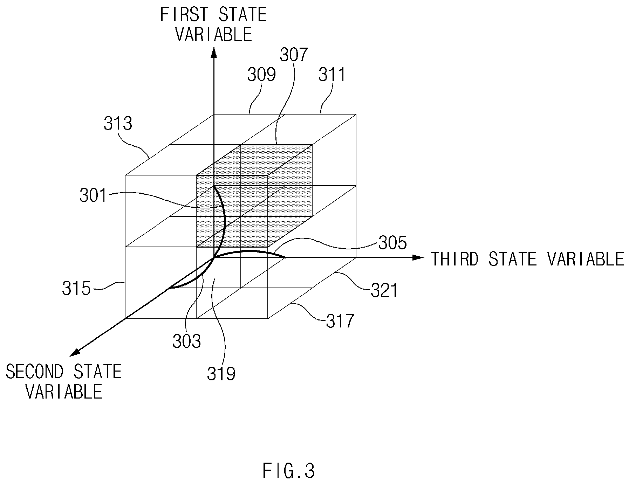

FIG. 3 illustrates an example of a data region, in the data analysis device and the data analysis method according to an embodiment of the present disclosure.

Referring to FIGS. 2 and 3, a data analysis device 201 may include a memory 203 and at least one processor 205. The memory 203 may store at least one instruction. The at least one processor 205 may execute the at least one instruction.

A first range may be one of a plurality of first ranges for dividing a first state variable by a first magnitude 301. A second range may be one of a plurality of second ranges for dividing a second state variable by a second magnitude 303. A third range may be one of a plurality of third ranges for dividing a third state variable by a third magnitude 305. A first data region, which is a battery data region 307, a second data region 309, a third data region 311, a fourth data region 313, a fifth data region 315, a sixth data region 317, a seventh data region 319, and an eighth data region 321 may each represent one of a plurality of data regions including at least one of the plurality of first ranges, the plurality of second ranges, the plurality of third ranges, or any combination thereof. The battery data region 307 may represent a region that includes a set of data among the plurality of data regions.

According to an embodiment, the set of data may include data measured from a battery cell. The data may include values of state variables of the battery cell (e.g., a voltage, current, temperature) over time. Data may be acquired from on-board diagnostics (OBD), but embodiments of the present disclosure may not be limited thereto.

According to an embodiment, at least one processor 205 of the data analysis device 201 may synthesize data and identify the synthesized data as a set of data. In other words, at least one processor 205 of the data analysis device 201 may identify, as the set of data, at least one of data on a value of the first state variable (e.g., temperature) of the battery cell over time, data on a value of the second state variable (e.g., voltage) of the battery cell over time, data on a value of the third state variable (e.g., current) of the battery cell over time, or any combination thereof.

According to an embodiment, at least one processor 205 of the data analysis device 201 may acquire the state of the battery cell (e.g., a remaining useful life (RUL)) from a learning model by inputting data into the learning model. This is because the degree of battery cell degradation is determined by an operating pattern of the battery cell that drive the electronic device. In this case, in order to reduce the computational load, at least one processor 205 of the data analysis device 201 may process data and input the processed data into the learning model.

According to an embodiment, the learning model may identify an operating pattern of the electronic device including the battery cell through the processed data. The learning model may diagnose a state of another battery cell of the same type as the battery cell, based on a relationship between the set of data and the state of the battery cell, according to a set of data of the other battery cell.

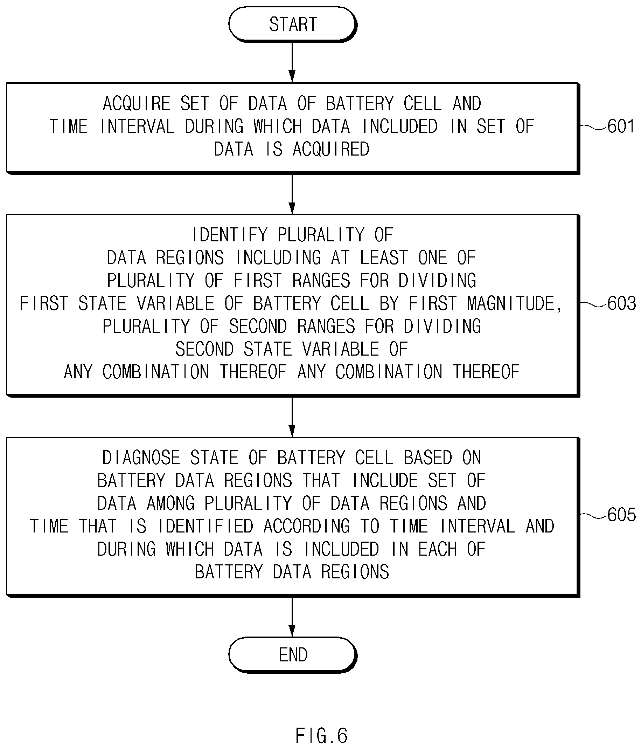

According to an embodiment, at least one processor 205 of the data analysis device 201 may determine at least one of the first magnitude 301 for dividing the first state variable, the second magnitude 303 for dividing the second state variable, the third magnitude 305 for dividing the third state variable, or any combination thereof. A method of determining at least one of the first magnitude 301, the second magnitude 303, the third magnitude 305, or any combination thereof is described below with reference to FIG. 6.

According to an embodiment, at least one processor 205 of the data analysis device 201 may identify a specified range for classifying data based on a median value of time intervals at which data is acquired. For example, the specified range may be identified as a time interval that is less than a value (e.g., about 12 seconds) calculated by multiplying a specified multiple (e.g., about 10 times) by the median value of the time intervals (e.g., about 1 second, about 3 seconds, about 1.3 seconds, about 1.2 seconds, about 1.1 seconds) at which data is acquired.

According to an embodiment, at least one processor 205 of the data analysis device 201 may identify a period corresponding to a first time interval during which the data is acquired as a rest period of the battery cell when the first time interval is within a specified range and may identify a period corresponding to a second time interval during which the data is acquired as an operating period of the battery cell when the second time interval is outside the specified range.

According to an embodiment, at least one processor 205 of the data analysis device 201 may identify a plurality of data regions (e.g., the battery data region 307, which is the first data region, the second data region 309, the third data region 311, the fourth data region 313, the fifth data region 315, the sixth data region 317, the seventh data region 319, and the eighth data region 321) that include at least one of a plurality of first ranges for dividing the first state variable of the battery cell by the first magnitude 301, a plurality of second ranges for dividing the second state variable of the battery cell by the second magnitude 303, a plurality of third ranges for dividing the third state variable of the battery cell by the third magnitude 305, or any combination thereof.

According to an embodiment, at least one processor 205 of the data analysis device 201 may identify battery data regions (e.g., the battery data region 307) that include a set of data among a plurality of data regions.

According to an embodiment, at least one processor 205 of the data analysis device 201 may identify a time during which data is included in the battery data region based on a time during which the first state variable included in the set of data is included in the first range corresponding to the battery data region, the second state variable included in the set of data is included in the second range corresponding to the battery data region, and the third state variable included in the set of data is included in the third range corresponding to the battery data region.

According to an embodiment, when a specific value of the first state variable of data acquired from the battery is included in a specific range of the first state variable indicated by the specific data region, a specific value of the second state variable of the data acquired from the battery is included in a specific range of the second state variable indicated by a specific data region, and a specific value of the third state variable of the data acquired from the battery is included in a specific range of the third state variable indicated by the specific data region, at least one processor 205 of the data analysis device 201 may identify that the data is included in a specific data region. At least one processor 205 of the data analysis device 201 may calculate, in an accumulated manner, a time during which the data acquired from the battery is included in the specific data region. At least one processor 205 of the data analysis device 201 may acquire a total time during which the data is included in the specific data region by summing the time from a moment when the data acquired from the battery is included in the specific data region to a moment when it leaves the specific data region.

According to an embodiment, at least one processor 205 of the data analysis device 201 may diagnose the state of the battery cell (e.g., remaining useful life of the battery cell) by inputting battery data regions (e.g., the battery data region 307) and times during which data is included in each of the battery regions into the learning model.

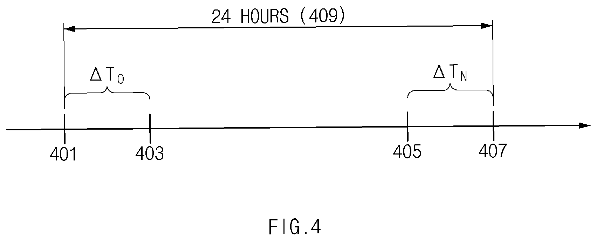

FIG. 4 illustrates an example of a time interval during which data is acquired, in a data analysis device and a data analysis method according to an embodiment of the present disclosure.

Referring to FIG. 4, a first point in time 401 may represent a start point in time of a specified period 409. A second point in time 403 may represent an acquisition point in time of first data acquired first during the specified period 409. A third point in time 405 may represent an acquisition point in time of second data acquired last during the specified period 409. A fourth point in time 407 may represent an end point in time of the specified period 409. The specified period 409 (e.g., a period from about 0:00 to about 24:00) may represent a period determined based on a reference for processing data.

According to an embodiment, a time interval $\Delta T_O$ at which the first data is acquired may include a time interval from the first point in time 401 (e.g., about 0:00) to the second point in time 403.

According to an embodiment, the time interval $\Delta T_N$ at which the second data is acquired may include a time interval from the third point in time 405 to the fourth point in time 407 (e.g., about 24 hours).

According to an embodiment, the time interval during which the second data is acquired may include the sum of the time interval from the third point in time 405 to the fourth point in time 407 (e.g., about 24 hours), and a time interval from a point in time at which data acquired immediately before the second data is acquired has been acquired to a third point in time 405.

According to an embodiment, at least one processor 205 of the data analysis device 201 may determine a minimum value of the first state variable among the plurality of data regions based on a minimum value of the first state variable in the data and the first magnitude. For example, the minimum value of the first state variable among the plurality of data regions may be determined through Equation 1.

[Equation 1]

$$V_{label,min} = floor\left(\frac{min(V)}{V_{bin}}\right) \times V_{bin}$$

For example, $V_{label,min}$ may represent the minimum value of the first state variable among the plurality of data regions. $V_{bin}$ may represent the first magnitude. min(V) may represent the minimum value of the first state variable in the data. Floor(x) may represent a function that rounds down the value of x.

According to an embodiment, at least one processor 205 of the data analysis device 201 may determine a maximum value of the first state variable among the plurality of data regions based on a maximum value of the first state variable in the data and the first magnitude. For example, the maximum value of the first state variable among the plurality of data regions may be determined through Equation 2.

[Equation 2]

$$V_{label,max} = ceil\left(\frac{max(V)}{V_{bin}}\right) \times V_{bin}$$

For example, $V_{label,max}$ may represent the maximum value of the first state variable among the plurality of data regions. $V_{bin}$ may represent the first magnitude. max(V) may represent the maximum value of the first state variable in the data. ceil(x) may represent a function that rounds up the value of x.

According to an embodiment, at least one processor 205 of the data analysis device 201 may diagnose the state of another battery cell of the same type as the battery cell based on a relationship between the set of data and the state of the battery cell, according to a set of data of the other battery cell.

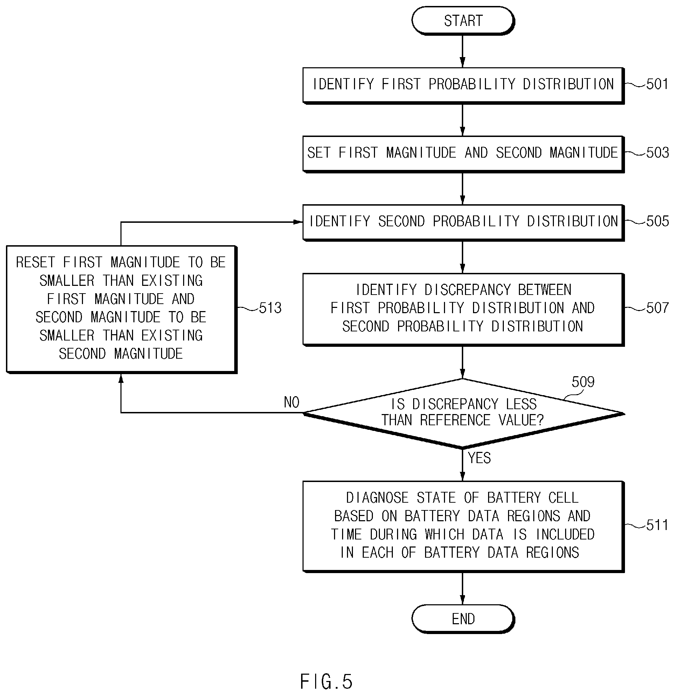

FIG. 5 illustrates an example of a flow of operations of a data analysis device for determining a first magnitude and a second magnitude, in a data analysis device and a data analysis method according to an embodiment of the present disclosure.

Hereinafter, it is assumed that at least one processor 205 of the data analysis device 201 of FIG. 2 performs a process of FIG. 5. In addition, in the description of FIG. 5, it may be understood that the operations described as being performed by the data analysis device 201 are controlled by at least one processor 205 of the data analysis device 201.

Referring to FIG. 5, in a first operation 501, according to an embodiment, at least one processor 205 of the data analysis device 201 may identify a first probability distribution (probability mass function (PMF)).

According to an embodiment, the first probability distribution may include a probability distribution during a specified period based on a value obtained by dividing a time during which data is acquired by a time corresponding to the specified period (e.g., about 24 hours). For example, a probability distribution during a specified period, which is identified based on a value obtained by dividing an accumulated acquisition time of specific data by the time corresponding to the specified period, may be identified.

In a second operation 503, according to an embodiment, at least one processor 205 of the data analysis device 201 may set the first magnitude and the second magnitude.

In a third operation 505, according to an embodiment, at least one processor 205 of the data analysis device 201 may identify a second probability distribution.

According to an embodiment, the second probability distribution may include a probability distribution for the specified period identified based on a value obtained by dividing a time during which the data is included in each of the battery data regions by the time corresponding to the specified period (e.g., about 24 hours). For example, the probability distribution for the specified period may be identified based on a value obtained by dividing a time during which the data is included in a particular battery data region by the time corresponding to the specified period.

In a fourth operation 507, according to an embodiment, at least one processor 205 of the data analysis device 201 may identify a discrepancy between the first probability distribution and the second probability distribution. This is because it may be determined, through the discrepancy, whether the set of data may be replaced with the battery data regions and the times during which the data is included in the respective battery data regions.

According to an embodiment, at least one processor 205 of the data analysis device 201 may identify a discrepancy between a first probability distribution of the set of data and a second probability distribution of the battery data regions. The discrepancy may include a Kullback-Leibler (KL) divergence between the first probability distribution (PMF) for the set of data and the second probability distribution (PMF) for the battery data regions. The KL divergence may be acquired through Equation 3.

[Equation 3]

$$D_{KL}(P \| Q) = \sum P(i) \log \frac{P(i)}{Q(i)}$$

For example, $D_{KL}(P \| Q)$ may represent the KL divergence between the first probability distribution and the second probability distribution. P(i) may represent the probability distribution according to the data included in the first probability distribution. Q(i) may represent the probability distribution according to the battery data region included in the second probability distribution.

In a fifth operation 509, according to an embodiment, at least one processor 205 of the data analysis device 201 may identify whether the discrepancy is less than a reference value. When the discrepancy is less than the reference value, at least one processor 205 of the data analysis device 201 may perform a sixth operation 511. When the discrepancy is greater than or equal to the reference value, at least one processor 205 of the data analysis device 201 may perform a seventh operation 513.

In the sixth operation 511, according to an embodiment, at least one processor 205 of the data analysis device 201 may diagnose the state of the battery cell based on the battery data regions and the time during which data is included in each of the battery data regions.

According to an embodiment, at least one processor 205 of the data analysis device 201 may identify a plurality of data regions and battery regions based on the first magnitude and the second magnitude when the discrepancy between the first probability distribution of the set of data and the second probability distribution of the battery data regions is less than the reference value.

According to an embodiment, at least one processor 205 of the data analysis device 201 may decrease the first magnitude and the second magnitude until the discrepancy becomes less than the reference value when the discrepancy between the first probability distribution of the set of data and the second probability distribution of the battery data regions is less than the reference value.

In the seventh operation 513, according to an embodiment, at least one processor 205 of the data analysis device 201 may reset the first magnitude to be smaller than the existing first magnitude, and reset the second magnitude to be smaller than the existing second magnitude.

According to an embodiment, at least one processor 205 of the data analysis device 201 may decrease the first magnitude and the second magnitude until the discrepancy becomes less than the reference value when the discrepancy between the first probability distribution of the set of data and the second probability distribution of the battery data regions is greater than or equal to the reference value.

FIG. 6 illustrates an example of a flow of operations of a data analysis device for diagnosing the state of a battery cell, in a data analysis device and a data analysis method according to an embodiment of the present disclosure.

Hereinafter, it is assumed that at least one processor 205 of the data analysis device 201 of FIG. 2 performs the process of FIG. 6. In addition, in the description of FIG. 6, it may be understood that the operations described as being performed by the data analysis device 201 are controlled by at least one processor 205 of the data analysis device 201.

Referring to FIG. 6, in the first operation 601, according to an embodiment, at least one processor 205 of the data analysis device 201 may acquire a set of data of a battery cell and a time interval during which data included in the set of data is acquired.

In the second operation 603, according to an embodiment, at least one processor 205 of the data analysis device 201 may identify a plurality of data regions including at least one of a plurality of first ranges for dividing a first state variable of the battery cell by a first magnitude, a plurality of second ranges for dividing a second state variable of the battery cell by a second magnitude, or any combination thereof.

In the third operation 605, according to an embodiment, at least one processor 205 of the data analysis device 201 may diagnose the state of the battery cell based on battery data regions that include the set of data among the plurality of data regions and a time that is identified according to a time interval and during which data is included in each of the battery data regions.

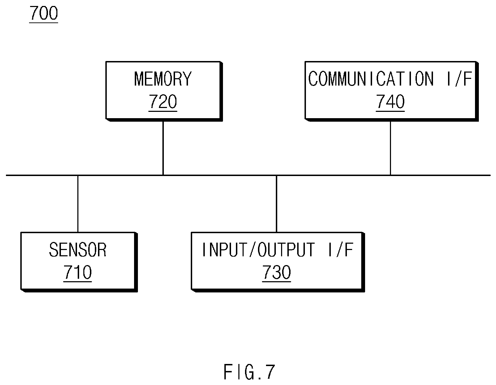

FIG. 7 is a block diagram illustrating a hardware configuration of a computing system that performs a data analysis method, in a data analysis device and a data analysis method according to an embodiment of the present disclosure.

Referring to FIG. 7, a computing system 700 according to an embodiment disclosed herein may include a microcontroller unit (MCU) 710, a memory 720, an input/output interface (I/F) 730, and a communication I/F 740.

The MCU 710 may be at least one processor that executes various programs (e.g., a battery cell data collection program, a graph generation program, a data analysis program, a data decomposition algorithm, a normalization program, a battery cell diagnosis program, and the like) stored in the memory 720, process various pieces of information including battery cell characteristic data, latent variables, and the like through the programs, and perform functions of the data analysis device 201 shown in the above-described FIGS. 2 to 6.

The memory 720 may store various programs such as the battery cell data collection program, the graph generation program, the data analysis program, the data decomposition algorithm, the normalization program, the battery cell diagnosis program, and the like.

A plurality of memories 720 may be provided as needed. The memory 720 may be a volatile memory or a non-volatile memory. As the volatile memory for the memory 720, a random-access memory (RAM), a dynamic RAM (DRAM), a static RAM (SRAM), or the like may be used. As the non-volatile memory for the memory 720, a read-only memory (ROM), a programmable ROM (PROM), an electrically alterable ROM (EAROM), an erasable programmable ROM (EPROM), an electrically erasable programmable ROM (EEPROM,) a flash memory, or the like may be used. The examples of memories 720 listed above are only exemplary and are not limited to the examples.

The input/output I/F 740 may provide an interface that connects an input device (not shown) such as a keyboard, a mouse, a touch panel, or the like, and an output device such as a display (not shown), to the MCU 710 to enable data transmission and reception.

The communication I/F 740 is a component that may transmit and receive various data to and from the server, and may be any device that may support wired or wireless communication. For example, the diagnostic device 201 may transmit and receive various types of information, including a shape model of a battery cell or the like, to and from a separately provided external server through the communication I/F 740.

By being recorded in the memory 720 and processed by the MCU 710 in this way, a computer program according to an embodiment disclosed herein may be implemented, for example, as a module that performs each of the functions shown in FIG. 2.

Although all the components constituting the embodiments disclosed herein have been described as being combined or operating in combination as one, the embodiments disclosed herein are not necessarily limited to these embodiments. That is, within the scope of the purpose of the embodiments disclosed herein, all of the components may be selectively combined and operated one or more times.

Terms such as "include," "comprise," or "have" described above mean that the corresponding component can be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The foregoing disclosure outlines features of several embodiments so that those skilled in the art may better understand the aspects of the present disclosure. Those skilled in the art will appreciate that the present disclosure may readily serve as a basis for designing or modifying other structures for carrying out the same purposes or achieving the same advantages of the embodiments introduced herein. Furthermore, those skilled in the art will recognize that such equivalent configurations do not depart from the scope of the present disclosure, and that various changes, substitutions, and modifications may be made herein without departing from the scope of the present disclosure.

**Claims**

1. A data analysis device comprising:

   a memory configured to store at least one instruction; and
   at least one processor configured to execute the at least one instruction,
   wherein the at least one processor is configured to:

   acquire a set of data of a battery cell and a time interval at which data included in the set of data is acquired;
   identify a plurality of data regions including at least one of a plurality of first ranges for dividing a first state variable of the battery cell by a first magnitude, a plurality of second ranges for dividing a second state variable of the battery cell by a second magnitude, or any combination thereof; and
   diagnose a state of the battery cell based on battery data regions including the set of data among the plurality of data regions and a time that is identified according to the time interval and in which the data is included in each of the battery data regions.

2. The data analysis device of claim 1, wherein the at least one processor is configured to:

   identify a period corresponding to a first time interval during which the data is acquired as a rest period of the battery cell when the first time interval is within a specified range; and
   identify a period corresponding to a second time interval during which the data is acquired as an operating period of the battery cell when the second time interval is outside the specified range.

3. The data analysis device of claim 2, wherein the specified range is determined based on a median value of time intervals at which data included in the set of data is acquired.

4. The data analysis device of claim 1, wherein the at least one processor is configured to diagnose a state of another battery cell of the same type as the battery cell based on a relationship between the set of data and the state of the battery cell, according to a set of data of the other battery cell.

5. The data analysis device of claim 1, wherein the at least one processor is configured to, when a discrepancy between the set of data and the battery data regions is greater than or equal to a reference value, decrease the first magnitude and the second magnitude until the discrepancy becomes smaller than the reference value, and
the discrepancy is configured to include a Kullback-Leibler (KL) divergence between a first probability distribution (probability mass function (PMF)) for the set of data and a second probability distribution (PMF) for the battery data regions.

6. The data analysis device of claim 5, wherein the at least one processor is configured to:

   acquire the first probability distribution (PMF) for a specified period based on a value obtained by dividing a time during which the data is acquired by a time corresponding to the specified period; and
   acquire the second probability distribution (PMF) for the specified period based on a value obtained by dividing a time during which the data is included in each of the battery data regions by the time corresponding to the specified period.

7. The data analysis device of claim 1, wherein a minimum value of the first state variable among the plurality of data regions is determined based on a minimum value of the first state variable in the data and the first magnitude, and
a maximum value of the first state variable among the plurality of data regions is determined based on a maximum value of the first state variable in the data and the first magnitude.

8. The data analysis device of claim 1, wherein the time interval of first data included in the set of data and acquired first during a specified period includes a time interval from a start point in time of the specified period to an acquisition point in time of the first data, and
the time interval of second data included in the set of data and acquired last during the specified time includes a time interval from an end point in time of the specified time to an acquisition point in time of the second data.

9. A data analysis method, comprising:

   acquiring a set of data of a battery cell and a time interval at which data included in the set of data is acquired;
   identifying a plurality of data regions including at least one of a plurality of first ranges for dividing a first state variable of the battery cell by a first magnitude, a plurality of second ranges for dividing a second state variable of the battery cell by a second magnitude, or any combination thereof; and
   diagnosing a state of the battery cell based on battery data regions including the set of data among the plurality of data regions and a time that is identified according to the time interval and in which the data is included in each of the battery data regions.

10. The data analysis method of claim 9, further comprising:

identifying a period corresponding to a first time interval during which the data is acquired as a rest period of the battery cell when the first time interval is within a specified range; and
identifying a period corresponding to a second time interval during which the data is acquired as an operating period of the battery cell when the second time interval is outside the specified range.

11. The data analysis method of claim 10, wherein the specified range is determined based on a median value of time intervals at which data included in the set of data is acquired.

12. The data analysis method of claim 9, further comprising diagnosing a state of another battery cell of the same type as the battery cell based on a relationship between the set of data and the state of the battery cell, according to a set of data of the other battery cell.

13. The data analysis method of claim 9, further comprising decreasing, when a discrepancy between the set of data and the battery data regions is greater than or equal to a reference value, the first magnitude and the second magnitude until the discrepancy becomes smaller than the reference value, wherein the discrepancy is configured to include a Kullback-Leibler (KL) divergence between a first probability distribution (PMF) for the set of data and a second probability distribution (PMF) for the battery data regions.

14. The data analysis method of claim 13, further comprising:

acquiring the first probability distribution (PMF) for a specified period based on a value obtained by dividing a time during which the data is acquired by a time corresponding to the specified period; and
acquiring the second probability distribution (PMF) for the specified period based on a value obtained by dividing a time during which the data is included in each of the battery data regions by the time corresponding to the specified period.

15. The data analysis method of claim 9, wherein a minimum value of the first state variable among the plurality of data regions is determined based on a minimum value of the first state variable in the data and the first magnitude, and
a maximum value of the first state variable among the plurality of data regions is determined based on a maximum value of the first state variable in the data and the first magnitude.

16. The data analysis method of claim 9, wherein the time interval of first data included in the set of data and acquired first during a specified period includes a time interval from a start point in time of the specified period to an acquisition point in time of the first data, and
the time interval of second data included in the set of data and acquired last during the specified period includes a time interval from an end point in time of the specified period to an acquisition point in time of the second data.

FIG.1

DATA ANALYSIS DEVICE
201

MEMORY
203

AT LEAST ONE PROCESSOR
205

FIG.2

FIRST STATE
VARIABLE

307
309        311

313

301

305

THIRD STATE VARIABLE

315

321

317

303

SECOND STATE
VARIABLE        319

FIG.3

24 HOURS (409)

$\Delta T_0$

$\Delta T_N$

401    403

405    407

FIG.4

START

IDENTIFY FIRST PROBABILITY DISTRIBUTION ～501

SET FIRST MAGNITUDE AND SECOND MAGNITUDE ～503

IDENTIFY SECOND PROBABILITY DISTRIBUTION ～505

RESET FIRST MAGNITUDE TO BE SMALLER THAN EXISTING FIRST MAGNITUDE AND SECOND MAGNITUDE TO BE SMALLER THAN EXISTING SECOND MAGNITUDE ～513

IDENTIFY DISCREPANCY BETWEEN FIRST PROBABILITY DISTRIBUTION AND SECOND PROBABILITY DISTRIBUTION ～507

NO — IS DISCREPANCY LESS THAN REFERENCE VALUE? 509

YES

DIAGNOSE STATE OF BATTERY CELL BASED ON BATTERY DATA REGIONS AND TIME DURING WHICH DATA IS INCLUDED IN EACH OF BATTERY DATA REGIONS ～511

END

FIG.5

START

ACQUIRE SET OF DATA OF BATTERY CELL AND
TIME INTERVAL DURING WHICH DATA INCLUDED IN SET OF
DATA IS ACQUIRED ~601

IDENTIFY PLURALITY OF
DATA REGIONS INCLUDING AT LEAST ONE OF
PLURALITY OF FIRST RANGES FOR DIVIDING
FIRST STATE VARIABLE OF BATTERY CELL BY FIRST MAGNITUDE, ~603
PLURALITY OF SECOND RANGES FOR DIVIDING
SECOND STATE VARIABLE OF
ANY COMBINATION THEREOF ANY COMBINATION THEREOF

DIAGNOSE STATE OF BATTERY CELL BASED ON
BATTERY DATA REGIONS THAT INCLUDE SET OF
DATA AMONG PLURALITY OF DATA REGIONS AND
TIME THAT IS IDENTIFIED ACCORDING TO TIME INTERVAL AND ~605
DURING WHICH DATA IS INCLUDED IN EACH OF
BATTERY DATA REGIONS

END

FIG.6

700

```
┌─────────────────┐        ┌──────────────────────┐
│     MEMORY      │        │  COMMUNICATION I/F   │
│      720        │        │         740          │
└────────┬────────┘        └───────────┬──────────┘
         │                             │
─────────┼──────────────┬──────────────┼──────────
         │              │
┌────────┴────────┐  ┌──┴───────────────────┐
│     SENSOR      │  │   INPUT/OUTPUT I/F    │
│      710        │  │         730          │
└─────────────────┘  └──────────────────────┘
```

FIG.7

EP 4 772 896 A1

**TRANSLATION**

## INTERNATIONAL SEARCH REPORT

International application No.

**PCT/KR2025/013086**

### A. CLASSIFICATION OF SUBJECT MATTER

**G01R 31/367**(2019.01)i; **G01R 31/396**(2019.01)i; **G01R 31/392**(2019.01)i; **G07F 17/18**(2006.01)i

According to International Patent Classification (IPC) or to both national classification and IPC

### B. FIELDS SEARCHED

Minimum documentation searched (classification system followed by classification symbols)

G01R 31/367(2019.01); G01R 19/00(2006.01); G01R 31/36(2006.01); G01R 31/385(2019.01); G01R 31/392(2019.01); G01R 31/396(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 배터리 셀(battery cell), 데이터 세트(data set), 시간 간격(time interval), 상태 변수 (state variable), 크기(size)

### C. DOCUMENTS CONSIDERED TO BE RELEVANT

| Category* | Citation of document, with indication, where appropriate, of the relevant passages | Relevant to claim No. |
|---|---|---|
| A | KR 10-2023-0066839 A (FLEXINK CO., LTD.) 16 May 2023 (2023-05-16)<br>paragraphs [0066]-[0067] and figure 12 | 1-16 |
| A | KR 10-2023-0157833 A (SAMSUNG ELECTRONICS CO., LTD.) 17 November 2023 (2023-11-17)<br>paragraphs [0068]-[0162] and figures 4a-11 | 1-16 |
| A | CN 109298351 A (GRADUATE SCHOOL AT SHENZHEN, TSINGHUA UNIVERSITY) 01 February 2019 (2019-02-01)<br>claim 1 and figure 1 | 1-16 |
| A | US 2024-0192276 A1 (ZITARA TECHNOLOGIES, INC.) 13 June 2024 (2024-06-13)<br>paragraphs [0019]-[0091] and figures 1-4 | 1-16 |
| A | KR 10-2023-0136497 A (THE REGENTS OF THE UNIVERSITY OF MICHIGAN) 26 September 2023 (2023-09-26)<br>paragraphs [0045]-[0075] and figure 1 | 1-16 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **28 November 2025** | **30 November 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 772 896 A1**

**TRANSLATION**

**INTERNATIONAL SEARCH REPORT**
**Information on patent family members**

International application No.

**PCT/KR2025/013086**

| Patent document cited in search report | | | Publication date (day/month/year) | Patent family member(s) | | | Publication date (day/month/year) |
|---|---|---|---|---|---|---|---|
| KR | 10-2023-0066839 | A | 16 May 2023 | KR | 10-2790688 | B1 | 08 April 2025 |
| KR | 10-2023-0157833 | A | 17 November 2023 | CN | 117031317 | A | 10 November 2023 |
| | | | | EP | 4277076 | A1 | 15 November 2023 |
| | | | | US | 2023-0358815 | A1 | 09 November 2023 |
| CN | 109298351 | A | 01 February 2019 | CN | 109298351 | B | 27 July 2021 |
| US | 2024-0192276 | A1 | 13 June 2024 | EP | 4409309 | A2 | 07 August 2024 |
| | | | | EP | 4409309 | A4 | 22 October 2025 |
| | | | | KR | 10-2024-0121276 | A | 08 August 2024 |
| | | | | US | 11971454 | B2 | 30 April 2024 |
| | | | | US | 12467976 | B2 | 11 November 2025 |
| | | | | US | 2023-0184839 | A1 | 15 June 2023 |
| | | | | WO | 2023-107710 | A2 | 15 June 2023 |
| | | | | WO | 2023-107710 | A3 | 27 July 2023 |
| KR | 10-2023-0136497 | A | 26 September 2023 | US | 2023-0296684 | A1 | 21 September 2023 |

Form PCT/ISA/210 (patent family annex) (July 2022)

**EP 4 772 896 A1**

**Patent documents cited in the description**

- KR 1020240136292